# EUROPEAN PATENT APPLICATION

(11) **EP 2 509 131 A1**
(43) Date of publication of application: **10.10.2012**
(21) Application number: 12161515.7
(22) Date of filing: 27.03.2012
(51) Int. Cl.: H01L 51/52

(54) **Method for transferring electrical gridlines on a lacquer layer**

(30) Priority: 08.04.2011 IN DE10182011
(71) Applicant: Moser Baer India Ltd., 110020 New Delhi (IN)
(72) Inventor: Stouwdam, Wiljan, 110020 New Dehli (IN); Bos, Matthijs, 110020 New Dehli (IN)
(74) Representative: Beck & Rössig European Patent Attorneys

(57) **Abstract**

In some embodiments of the present invention a method is provided for simultaneously forming electrical circuitry (206, 314) and functional light structures (204) on a curable lacquer layer (106, 122) deposited on a base substrate (104, 120) of an organic optoelectronic device (100a, 100b). The method includes applying (406) the lacquer layer (106, 122) on the base substrate (104, 120), contacting (410) a transfer substrate (300) against said curable lacquer layer (106, 122), curing the curable lacquer layer (106, 122) and removing the transfer substrate (300). Characterised in the method, contacting the transfer substrate (300) includes mating a mating surface (310) of the transfer substrate (300) with the curable lacquer layer (106, 122). The mating surface (310) has the electrical circuitry (314) on a first portion and negative impressions (312) of the functional light structures (204) on a second portion, such that the electrical circuitry (314) is releasably adhered to the mating surface (310). Further, the adhesion between the transfer substrate (300) and the electrical circuitry (314) is substantially lesser than adhesion between the electrical circuitry (314) and the curable lacquer layer (106, 122), contacting enables simultaneously embedding some or all of the electrical circuitry (314) in the curable lacquer layer (106, 122) as well as replication of the functional light structures (204) onto the curable lacquer layer (106, 122). Further, characterized in the method, the curing facilitates affixing the electrical circuitry (314) on the curable lacquer layer (106, 122).

## Description

### FIELD OF INVENTION

The invention disclosed herein relates, in general, to semiconductor devices. More specifically, the present invention relates to a method of applying electrical gridlines in the semiconductor devices.

### BACKGROUND

Electrode layers in semiconductor devices like thin film photovoltaic devices (TF-PVs) or organic light emitting devices (OLEDs) are commonly made of transparent conductive oxides (TCO), such as indium tin oxide (ITO), antimony doped tin oxide and cadmium tin oxide.

TCO layers work substantially well for small area semiconductor devices, however, in cases of large area semiconductor devices, conductivity provided by the TCO layer is not sufficient. Due to insufficient conductivity, often there is a voltage drop in the semiconductor device. For example, in case of the OLEDs the voltage drop can be seen as inhomogeneous light intensity in the OLEDs.

This problem can be possibly countered by using a thicker electrode layer. The thicker electrode layer provides a decreased resistance and thereby reduces the voltage drop. However, the transmittance decreases significantly when using the thicker electrode layer.

Therefore, another solution that is also used to increase the conductivity provided by the electrode layer, includes application of electrically conducting gridlines in the semiconductor device to supplement the conductivity of the electrode layer.

The electrically conducting gridlines can be formed on a surface in the semiconductor device by several methods, for example by photolithography. However, photolithography is an expensive process. Besides the costs of setting up the apparatus for photolithography, disposal of waste material produced in the photolithography process is also expensive.

Additionally, the photolithography process allows only a limited number of substrate elements to be processed in a single production cycle, resulting in a low process throughput.

A less-expensive process of fabricating the electrically conducting gridlines is printing. However, a structure resolution that can be achieved using the printing process is relatively coarse.

Further, the processes used in the prior art result in formation of the gridlines protruding from the surface. This protrusion leads to problems in functioning of the semiconductor device.

In light of the above discussion, there is a need for an improvement in the method of transferring / application of electrically conducting gridlines to the semiconductor device, that overcome one or more drawbacks present in the prior art.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIGs. 1a and 1b illustrate a stack of layers in an exemplary OLED and an exemplary TF-PV device, respectively, in accordance with an embodiment of the present invention;
FIGs. 2a and 2b illustrates a cross-sectional view and a top view, respectively, of an exemplary stage during manufacturing of an exemplary organic optoelectronic device after transfer of an electrical circuitry and functional light structures in accordance with an embodiment of the present invention;
FIGs. 3a, 3b, 3c, 3d and 3e illustrate a schematic view of different stages of formation of an exemplary transfer substrate, in accordance with an embodiment of the present invention; and
FIG. 4 is a flow chart describing an exemplary process of manufacturing an organic optoelectronic device, in accordance with an embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### SUMMARY

The invention provides a method of simultaneously forming electrical circuitry and functional light structures on a curable lacquer layer deposited on a base substrate for use in an organic optoelectronic device, for example, an OLED. The method includes stamping a transfer substrate, which includes both the electrical circuitry and the negative impressions of the functional light structures, against the curable lacquer layer of the OLED. The electrical circuitry, which is in the form of busbars, is releasably adhered to the transfer substrate such that the busbars get transferred to the curable lacquer layer during stamping almost simultaneous to the formation of functional light structures on the curable lacquer layer.

Also, the bus bars get almost completely embedded in the curable lacquer layer, therefore, a flat surface is provided for any subsequent layers, for example, electrode layers to be deposited. This prevents any in-homogeneity in thickness of the electrode layers and also prevents any subsequent electronic problems.

In some embodiments of the present invention a method is provided for simultaneously forming electrical circuitry and functional light structures on a curable lacquer layer deposited on a base substrate of an organic optoelectronic device. The method includes applying the lacquer layer on the base substrate, contacting a transfer substrate against said curable lacquer layer, curing the curable lacquer layer and removing the transfer substrate. Characterised in the method, contacting the transfer substrate includes mating a mating surface of the transfer substrate with the curable lacquer layer. The mating surface has the electrical circuitry on a first portion and negative impressions of the functional light structures on a second portion, such that the electrical circuitry is releasably adhered to the mating surface. Further, the adhesion between the transfer substrate and the electrical circuitry is substantially lesser than adhesion between the electrical circuitry and the curable lacquer layer, contacting enables simultaneously embedding some or all of the electrical circuitry in the curable lacquer layer as well as replication of the functional light structures onto the curable lacquer layer. Further, characterized in the method, the curing facilitates affixing the electrical circuitry on the curable lacquer layer.

In some embodiments of the present invention a transfer substrate is provided for simultaneously forming electrical circuitry and functional light structures on a curable lacquer layer deposited on a base substrate of an optoelectronic device. The transfer substrate includes a mating surface configured to be contacted against the curable lacquer layer. Characterised in the transfer substrate, the mating surface includes a first portion, to which the electrical circuitry is releasably adhered such that adhesion between the transfer substrate and the electrical circuitry is substantially lesser than adhesion between the electrical circuitry and the curable lacquer layer. Further, the mating surface also includes a second portion having negative impressions of the functional light structures. The transfer substrate enables simultaneous embedding of some or all of the electrical circuitry in said curable lacquer layer and replication of the functional light structures onto said curable lacquer layer when the mating surface is contacted against the curable lacquer layer.

In some embodiments, the electrical circuitry is electric gridlines for establishing electrical current paths across the base substrate.

In some embodiments, the transfer substrate is a flexible transfer substrate.

In some embodiments, the curable lacquer layer further comprises scattering particles.

In some embodiments, the organic optoelectronic device is one of a Thin Film Photovoltaic Device (TF-PV) and an Organic Light Emitting Device (OLED).

In some embodiments, the curing process is selected from at least one of a thermal curing and a photo curing.

### DESCRIPTION OF THE EXEMPLARY EMBODIMENTS

Before describing the present invention in detail, it should be observed that the present invention utilizes a combination of method steps and apparatus components related to a method of manufacturing a semiconductor device. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

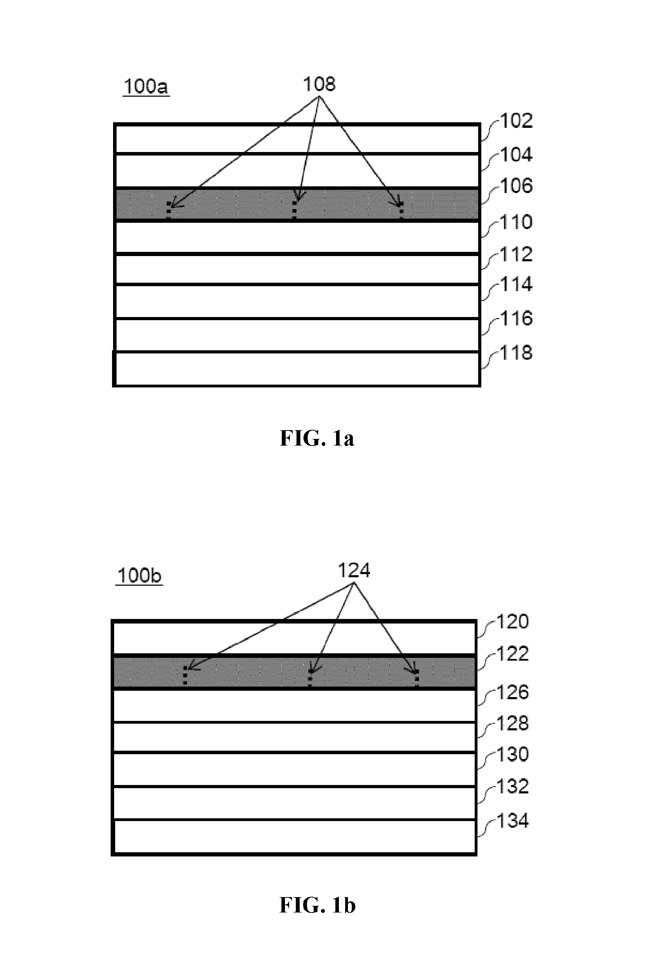

Referring now to the drawings, there is shown in FIG. 1a, a stack of layers in an exemplary OLED 100a, in accordance with an embodiment of the present invention. The OLED 100a is shown to include an external light extraction layer 102, a base substrate 104, an internal light extraction layer 106, electrical circuitry 108, a first electrical contact 110, one or more organic layers 112 and 114, a second electrical contact 116 and a cover substrate 118, which encapsulates the internal light extraction layer 106, the electrical circuitry 108, the first electrical contact 110, the one or more organic layers 112 and 114, and the second electrical contact 116 between itself and the base substrate 104.

The internal extraction layer 106 is formed of curable lacquer, therefore, in some portions of the description it is termed as curable lacquer layer 106.

For the purpose of the description, the OLED 100a has been shown to include only those layers that are pertinent to the description of the invention. However, it should be understood that the invention is not limited to the layers listed above. In some cases, the OLED 100a may include additional layers to enhance efficiency or to improve reliability, without deviating from the scope of the invention.

Some real life examples of the OLED 100a can include, but are not limited to, Organic Light Emitting Diode (OLED), White Organic Light Emitting Diode (W-OLED), Active-matrix Organic Light Emitting Diodes (AMOLED), Passive-matrix Organic Light Emitting Diodes (PMOLED), Flexible Organic Light Emitting Diodes (FOLED), Stacked Organic Light Emitting Diodes (SOLED), Tandem Organic Light Emitting Diode, Transparent Organic Light Emitting Diodes (TOLED), Top Emitting Organic Light Emitting Diode, Bottom Emitting Organic Light Emitting Diode, Fluorescence doped Organic Light Emitting Diode (F-OLED) and Phosphorescent Organic Light Emitting Diode (PHOLED).

The base substrate 104 provides strength to the OLED 100a, and also acts as an emissive surface of the OLED 100a when in use. The examples of the base substrate 104 include, but are not limited to, glass, flexible glass, polyethylene terephthalate (PET), polyethylene naphthalate (PEN), and other transparent or translucent material.

The first electrical contact 110 and the second electrical contact 116 are used to apply a voltage across the one or more organic layers 112 and 114. The first electrical contact 110 and can be implemented with a transparent conductive layer (TCL), for example, a transparent conductive oxide (TCO), PEDOT-PSS, any other transparent polymers, or thin layers. TCOs are doped metal oxides, examples of TCOs include, but are not limited to, Aluminum-doped Zinc Oxide (AZO), Indium Zinc Oxide (IZO), Boron doped Zinc Oxide (BZO), Gallium doped Zinc Oxide (GZO), Fluorine doped Tin Oxide (FTO) and Indium doped Tin Oxide (ITO). Further, the second electrical contact 116 can be implemented with metals with appropriate work function to make injection of charge carriers, for example, calcium, aluminum, gold, and silver.

The one or more organic layers 112 and 114 can be implemented with any organic electroluminescent material such as a light-emitting polymer, evaporated small molecule materials, light-emitting dendrimers or molecularly doped polymers.

In an OLED light emitted by the one or more organic layers 112 and 114 needs to pass through the base substrate 104. However, when light is incident from a high refractive index material onto an interface with a lower refractive index material or medium, the light undergoes total internal reflection (TIR) for all incidence angles greater than the critical angle θ_{c}, defined by θ_{c} = sin⁻¹ (n₂/n₁), where n₁ and n₂ are the refractive indices of the high refractive index material and low refractive index material, respectively. Due to the same reason, when the light emitted by the one or more organic layers 112 and 114 reaches an interface with the base substrate 104, a substantial amount of light is reflected back into the one or more organic layers 112 and 114.

This can be prevented by presence of an internal light extraction layer 106 having functional light structures, as the functional light structures are capable of changing the propagation direction of the light emitted by the one or more organic layers 112 or 114 at the interface with the base substrate 104. This helps to reduce the reflection (or TIR) of the light back into the OLED 100a. The functional light structures on the internal light extraction layer 106 may include geometries having dimensions in the order of the wavelength of the light to facilitate the change in propagation direction of the emitted light by diffraction. The functional light structures on the internal light extraction layer 106 may also include geometries having larger dimensions than the wavelength of the light to facilitate the change in propagation direction of the emitted light by refraction. Therefore, presence of an internal light extraction layer 106 having functional light structures to act as the absorbing and the scattering entities which eliminates or reduces the TIR, increases the efficiency of the OLED 100a. In a similar manner, the external light extraction layer 102 reduces or eliminates the TIR at an interface between the base substrate 104 and an ambient medium.

The functional light structures can bring about a change in the light propagation direction by either diffraction or refraction. Usually, the functional light structures having dimensions in the order of a wavelength of the light, usually change the light propagation direction by diffraction. Examples of the functional light structures that change the light propagation direction by diffraction include, but are not limited to, a 1D grating and a 2D grating. The functional light structures having dimensions larger than a wavelength of the light, usually change the light propagation direction by refraction. Examples of the functional light structures that change the light propagation direction by refraction include, but are not limited to, a lens, a cone, and a pyramid.

Additionally, in cases of large area OLEDs, conductivity provided by a TCO layer of the first electrical contact 110 is not sufficient, leading to a voltage drop in the large area OLEDs. This voltage drop can be seen as inhomogeneous light intensity in the large area OLEDs. This can be prevented by providing the electrical circuitry 108 in addition to the first electrical contact 110. The electrical circuitry 108 can supplement the conductivity provided by the first electrical contact 110. The electrical circuitry 108 can be in the form of a grid of highly conductive metal lines or busbars or electrical gridlines or circuits that are capable of providing an electric current path across entire surface of the base substrate 104 and the first electrical contact 110. For example in an OLED, this ensures that a uniform voltage is provided across the entire surface and that there is no voltage drop causing inhomogeneous light emission. In the figure the electrical circuitry 108 is shown to be embedded in the internal light extraction layer 106 such that the electrical circuitry 108 does not protrude out of a surface of the internal light extraction layer 106, thereby providing a flat surface for the first electrical contact 110 to be deposited. This in turn prevents any in-homogeneity in thickness of the first electrical contact 110 and also prevents any electronic problems or device degradation. In an embodiment, the electrical circuitry 108 has a surface coverage of less than 10%. Further, a width of each metal line or each busbar in the electrical circuitry 108 ranges from about 50 µm (microns) to a few millimeters, e.g. 2, 5, or 10 millimeters. Further, a height of each metal line or each busbar in the electrical circuitry 108 ranges from 200 nm to 50 µm (micron).

In another embodiment, a planarization layer may be provided between the first electrical contact 110 and the internal light extraction layer 106. The planarization layer provides a flat surface for the first electrical contact 110 to be deposited. The planarization layer is usually made of a high refractive index material than the internal light extraction layer 106, so as to not impede light extraction.

Referring now to FIG. 1b, there is shown a stack of layers in an exemplary TF-PV device 100b, in accordance with an embodiment of the present invention. The TF-PV device 100b is shown to include a transparent substrate 120, a light trapping layer 122, electrical circuitry 124, a first electrical contact 126, one or more absorber layers 128 and 130, a second electrical contact 132 and a cover substrate 134. In an embodiment, the TF-PV device can be an organic photovoltaic device or an inorganic photovoltaic device and the one or more absorber layers 128 and 130 include both inorganic and organic semiconductor material.

The light trapping layer 122 is formed of curable lacquer, therefore, in some portions of the description it is termed as curable lacquer layer 122.

In the TF-PV device 100b, the light falling on the one or more organic layers 128 and 130 enable generation of electricity through the absorber layers 128 and 130, which is extracted into external circuits by the first and second electrical contacts 126 and 132. In the TF-PV device 100b, the light trapping layer 122 including functional light structures is provided to increase an optical path of the light transmitted in to the TF-PV device 100b. Similarly, as described for OLED 100a, in cases of large area TF-PV devices, conductivity provided by a TCO layer of the first electrical contact 126 is not sufficient, leading to a voltage drop in the large area TF-PV devices. This voltage drop can be prevented by providing the electrical circuitry 124 in addition to the first electrical contact 126. The electrical circuitry 124 is similar in characteristics to the electrical circuitry 108 defined in conjunction with FIG. 1a.

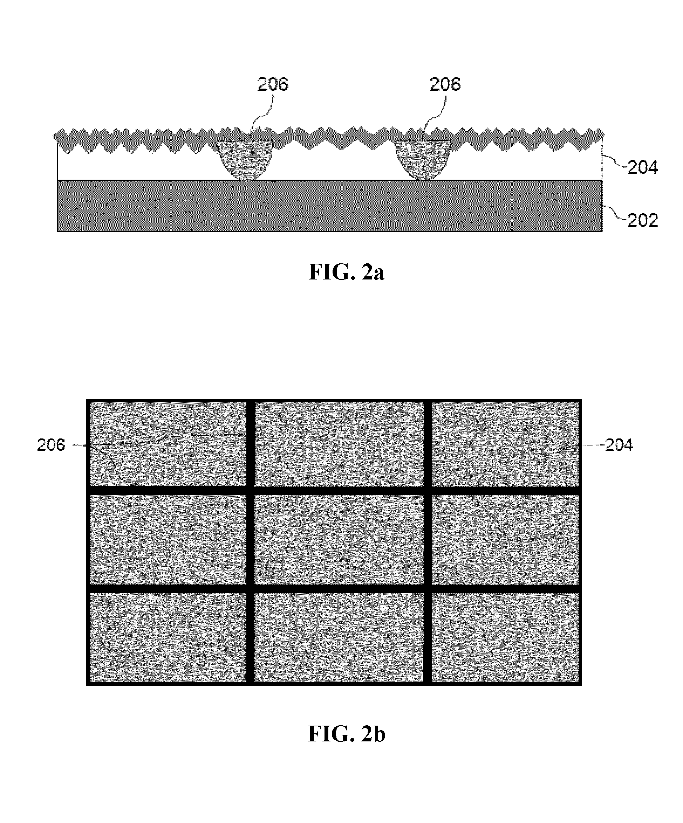

Moving on to FIG. 2a, there is illustrated a cross-sectional view of an exemplary stage during manufacturing of an exemplary organic optoelectronic device, for example, the OLED 100a and the TF-PV 100b shown in FIGs 1a and 1b. The stage shown is after an electrical circuitry 206 and functional light structures 204 have been transferred to the base substrate 202. The functional light structures 204 as described in conjunction with FIGs. 1a and 1b enable light extraction and light trapping in cases of an OLED and a TF-PV device respectively. The functional light structures 204 are usually sub-micron sized micro-textures that are preferably one of periodic and quasi-periodic in nature. The functional light structures are usually formed on the organic optoelectronic device by a replication process. According to the replication process a transfer substrate having a micro-textured surface corresponding to a negative impression of the functional light structures 204 is contacted with a curable lacquer layer deposited onto the base substrate 202, thereby imprinting the functional light structures 204 onto the curable lacquer layer. In an embodiment, the electrical circuitry is attached such that, adhesion between the transfer substrate and the electrical circuitry 206 is substantially lesser than adhesion between the electrical circuitry 206 and the curable lacquer layer. In an embodiment, the curable lacquer layer can include scattering particles that further enhance light management properties of the organic optoelectronic device. Also, any angular colour shift problems are reduced because of the presence of the scattering particles. Scattering using the scattering particles may be obtained by using a curable lacquer layer that has a refractive index gradient, or consists of more than one layer, each having different refractive indices. Alternatively, a curable lacquer layer with TiO₂ or ZrO₂ particles, or similar, may be used. Also a curable lacquer layer with voids or air or vacuum can be used for obtaining scattering.

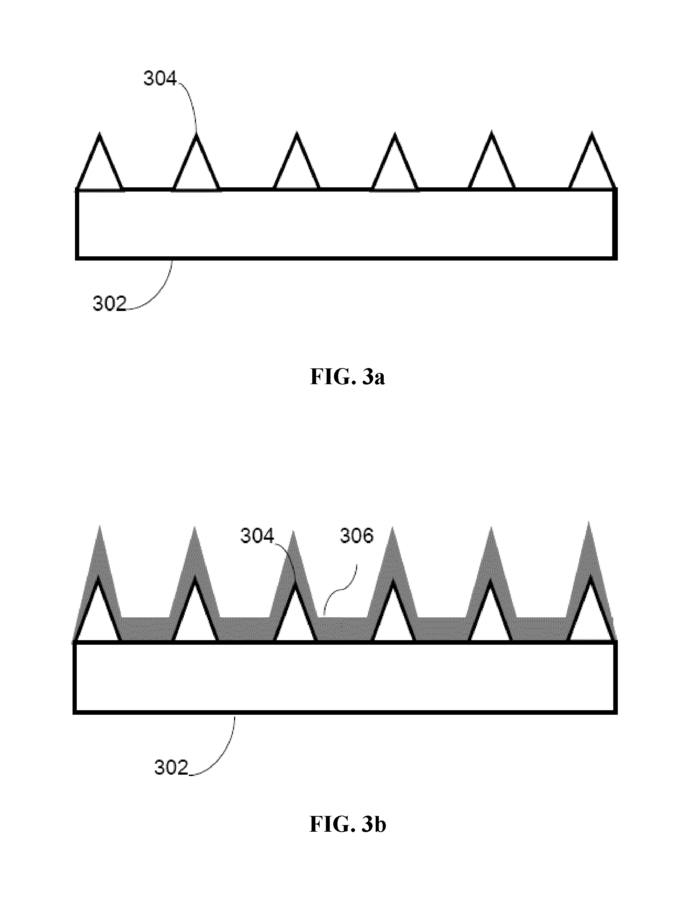

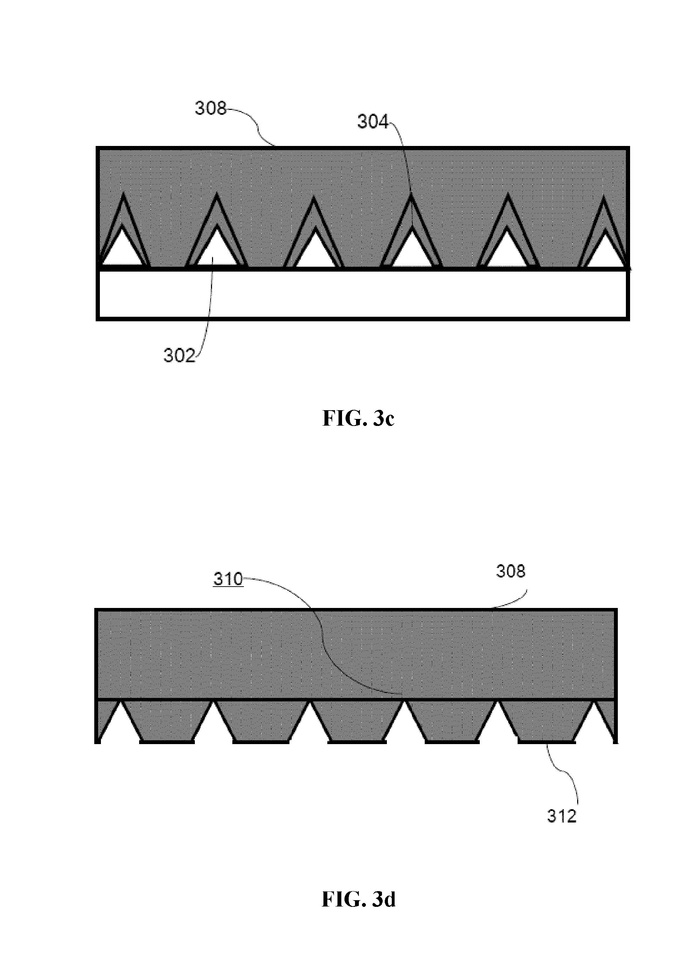

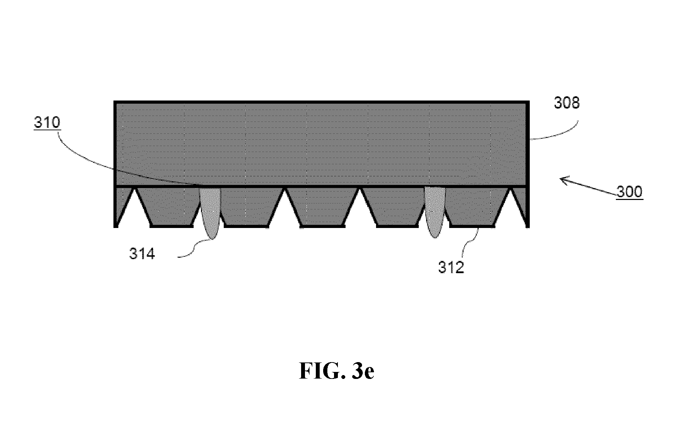

According to the present invention, the transfer substrate used for forming the functional light structures 204, also includes the electrical circuitry 206 in addition to the negative impression of the functional light structures 204. The transfer substrate will be explained in greater detail in conjunction with FIG. 3.

In an embodiment, a layer of a curable material, such as a photo-polymer lacquer or a sol-gel material is applied onto the base substrate 202. Thereafter, the transfer substrate including the electrical circuitry 206 in addition to the negative impression of the functional light structures 204 is pressed into the layer of the curable material. This results in imprinting of the functional light structures 204 on the layer of the curable material and also a simultaneous embedding of at least a portion of the electrical circuitry 206 in the curable lacquer layer. In an embodiment, the functional light structures 204 and the electrical circuitry 206 are transferred such that that the electrical circuitry 206 does not protrude out of a surface of the functional light structures 204, thereby a flat surface is formed for subsequent deposition of the first electrical contact. This will help in preventing any in-homogeneity in thickness of the first electrical contact and thereby prevent any electronic problems in future. FIG. 2b illustrates a top view of the exemplary organic optoelectronic device at the stage shown in FIG. 2a. As can be seen the electrical circuitry 206 is in the form of grid lines extending across the surface and is shown to occupy a first portion of the substrate. Further, the functional light structures 204 can also be seen to occupy a second portion represented by the shaded part of the figure.

The functional light structures 204 and the electrical circuitry 206 shown in the figure are mere illustrations and have been provided for the purpose of easy description of the invention. It should be understood that the figures have not been drawn to scale and have been drawn to provide an easy understanding of the concept behind the invention.

As can be seen from above, in order to produce the functional light structures and the electrical circuitry a transfer substrate needs to be formed. FIGs. 3a, 3b, 3c, 3d and 3e illustrate a schematic view of different stages of formation of an exemplary transfer substrate 300, in accordance with an embodiment of the present invention. The transfer substrate 300 is shown to include a base 308, a mating surface 310, functional light structures 312 and electrical circuitry 314.

Referring to FIG. 3a there is shown a father substrate 302 carrying impressions 304 of the functional light structures. The father substrate 302 usually includes a base having a photo-resist layer applied on top of the base. Examples of the base of the father substrate 302 include, but are not limited to, a glass plate, a semiconductor wafer and a flat metal plate. Examples of the photo-resist layer can be any phase-transition material like novolac.

In an embodiment, a photo-lithographic process or thermo-lithographic process is carried out on the photo-resist layer to form the impressions 304 of the functional light structures. However, it should be appreciated that the impressions 304 of the functional light structures, can also be formed using processed like laser beam recording, E-beam lithography, projection lithography, nano-imprint lithography, and holography. Though the method has been described in relation to photo-lithographic process, it is not intended to be limiting but rather to provide an understandable description of the invention.

During the process the photo-resist layer is locally illuminated by using a focused sub-micron-sized laser spot (less than 1 µm). The laser spot can be scanned over the photo-resist layer, either by moving the substrate under a stationary spot, or by moving the spot over a stationary substrate, or by a combination of both. In real life applications, a rotating substrate in combination with a linearly moving laser spot in the radial direction is used. In another embodiment, an x,y-stage may be used to move either the substrate or the laser spot in the lateral direction.

The details of the impressions 304 of the functional light structures can be modulated. Also, the process allows formation of a variety of feature and shapes as the impressions 304 of the functional light structures. For example, continuous intensity of the laser spot combined with a constant linear movement of the substrate will result in line-shaped features, whereas a pulse-modulated laser spot will result in dot- or dash-shaped features.

Further, height of the impressions 304 of the functional light structures can also be controlled. Lateral size features of the impressions 304 of the functional light structures can also be modulated. Usually, features that can be produced using the focused laser spot have dimensions in the order of the wavelength of the light being used.

After development of the father substrate 302, the father substrate 302 is duplicated to form a plurality of the transfer substrate 300. This duplication process is required for mass production of the transfer substrate 300, as use of photolithography is expensive and scaling up of photolithography to form a plurality of the transfer substrate 300 is not economically viable, hence transfer substrate needs to be produced using an economical process from the father substrate 302.

In an embodiment, the father substrate 302 can be duplicated by using an electroplating process. However, it should be appreciated that other methods are also possible. Moving on to FIG. 3b, in the electro-plating process the father substrate 302 is sputtered with a metal layer, typically a nickel-alloy or a silver-alloy, to form a conducting electrode and a seed layer 306 for plating process. In an embodiment, the transfer substrate can be a flexible transfer substrate.

Subsequently moving on to FIG. 3c, a transfer substrate 300 is grown on top of the seed layer 306. The transfer substrate 300 is typically metallic, like nickel or silver. The transfer substrate 300 is subsequently removed from the father substrate 302, and includes a base 308 having a mating surface 310. The mating surface 310 is the surface of the transfer substrate 300 that contacts with the curable lacquer layer deposited on the base substrate of the organic optoelectronic device. The mating surface 310 further includes a negative impression 312 of the functional light structures on a first portion of its surface as can be seen in FIG. 3d. The negative impressions can be explained in light of FIGs. 3a and 3d. The impressions 312 are a negative impression of the impressions 304 and vice versa. For example, if a conical shape is desired in the functional light structures to be formed on the base substrate of the organic optoelectronic device, then a corresponding hollow cone will be provided in the negative impressions 312 on the transfer substrate.

Thereafter, as shown in FIG. 3e the electrical circuitry 314 is releasably attached to a second portion of the mating surface 310 by treating the mating surface by use of a lubricant or a surfactant so that the electrical circuitry 314 is attached to the mating surface. The treatment used to attach the electrical circuitry 314 to the transfer substrate 300 is such that an adhesion provided between the transfer substrate 300 and the electrical circuitry 314 is substantially lesser than adhesion between the electrical circuitry 314 and the curable lacquer layer.

The transfer substrate 300 has the advantage of having highly optimized and efficient designs of the functional light structures. Further, the electro-plating process used is very accurate up to dimensions on sub-micron size scale and also allows easy and inexpensive scale up to large area surfaces. Additionally, the functional light structures' features can be precisely optimized and controlled. Also, lateral dimensions and depth of the functional light structures' features can be optimized independently. The functional light structures are periodic or quasi-periodic structures with a controlled and precise distance at sub-micron level.

The functional light structures, the electrical circuitry, the transfer substrate shown in the figure are mere illustrations and have been provided for the purpose of easy description of the invention. It should be understood that the figures have not been drawn to scale and have been drawn to provide an easy understanding of the concept behind the invention.

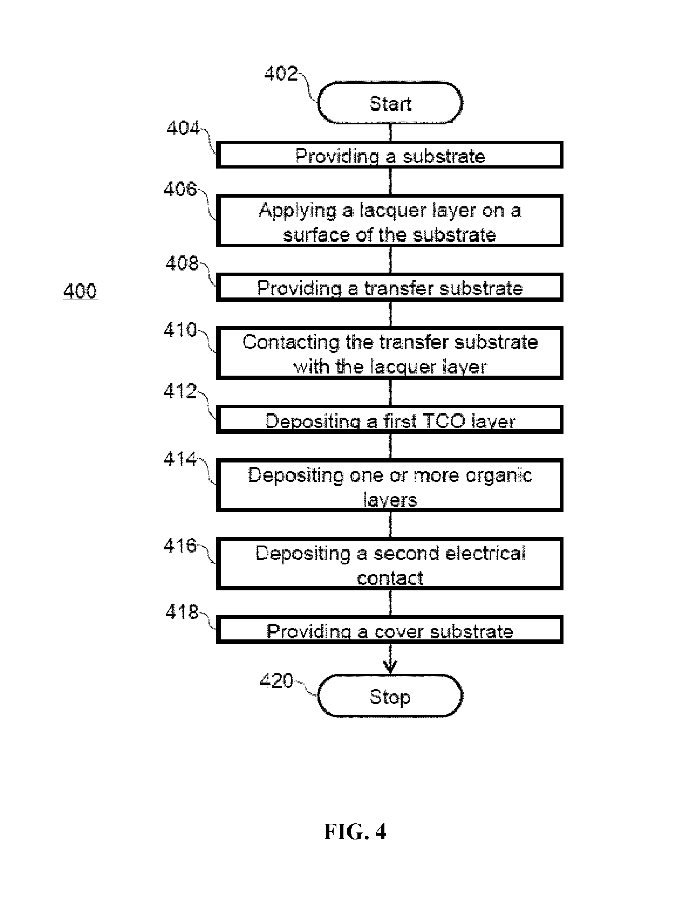

Moving on to FIG. 4, there is shown a flowchart depicting a method 400 of manufacturing an organic optoelectronic device, for example the OLED 100a, in accordance with an embodiment of the present invention. To describe the method 400, reference will be made to FIGs. 1, 2 and 3, although it is understood that the method 400 can be implemented to manufacture any other suitable device. Moreover, the invention is not limited to the order of in which the steps are listed in the method 400. In addition, the method 400 can contain a greater or fewer numbers of steps than those shown in FIG. 4.

Further, for the purpose of description, the method 400 has been explained in reference to an OLED and light extraction, however, it will be readily apparent to those ordinarily skilled in the art that the present invention can be implemented in an TF-PV device as well for light management purposes, like, light trapping.

The method 400 is initiated at step 402. At step 404, a substrate, for example the base substrate 104, having a substantially flat surface is provided.

Thereafter, at step 406 a curable lacquer material is applied on the base substrate 104 to form a curable lacquer layer. Examples of the curable lacquer material can include, but is not limited to, an ultra-violet curable material, a photo-polymer lacquer, an acrylate, and silica or silica-titania based sol-gel materials. However, it should be understood that the curable lacquer layer can be formed of any material having similar characteristics without deviating from the scope of the invention. Further, the lacquer can be deposited by using a brush or roller, dispensing, slot dye coating, spin-coating, spray coating, or printing.

Thereafter, at step 408 a transfer substrate, for example the transfer substrate 300, is provided. The transfer substrate 300 includes negative impression 312 of the functional light structures and the electrical circuitry 314 on its mating surface 310. The transfer substrate 300 is contacted with the curable lacquer material to replicate the functional light structures onto the curable lacquer layer and also simultaneously transfer the electrical circuitry 314 at step 410. Referring to FIG. 2a, formation of the electrical circuitry 206 and the functional light structures 204 on the base substrate 202 can be seen.

Several methods of replication are possible, in an embodiment a photo- curable lacquer, such as a photo-polymer lacquer or a sol-gel material can be applied onto the base substrate 104. Thereafter, the transfer substrate 300 can be contacted with the lacquer layer imprinting the functional light structures and also transferring the electrical circuitry to the lacquer layer. This can be followed by application of a photo- curing process to affix the functional light structures and the electrical circuitry 314 on the curable lacquer layer on surface of the base substrate 104.

In another embodiment, a thermally curable lacquer, such as a photo-polymer lacquer or a sol-gel material can be applied onto the base substrate 104. Thereafter, the transfer substrate 300 can be contacted with the lacquer layer, thereby imprinting the functional light structures and also embedding at least a portion of the electrical circuitry in the lacquer layer. This can be followed by application of heat to affix the functional light structures and the electrical circuitry 314 on the curable lacquer layer on surface of the base substrate 104

The method 400 allows simultaneous formation of periodic or quasi-periodic functional light structures and electrical circuitry on the base substrate 104, thereby saving production time during manufacture of the organic optoelectronic device.

Subsequently, at step 412, a TCO layer, for example the first electrical contact 110 is deposited with conventional known methods on the internal light extraction layer 106. The first electrical contact 110 deposited. The first electrical contact 110 can be deposited by using various methods, such as dip coating, spin coating, doctored blade, spray coating, screen printing, sputtering, glass mastering, photoresist mastering, electroforming, and evaporation. In an embodiment, the first electrical contact 110 acts as an anode.

Thereafter, at step 414, one or more organic layers, for example the one or more organic layers 112 and 114 are deposited on the first electrical contact 110. The one or more organic layers 112 and 114 can be deposited by using various methods, such as dip coating, spin coating, doctored blade, spray coating, screen printing, sputtering, glass mastering, photoresist mastering, all kinds of CVD, electroforming, and evaporation.

Thereafter, at steps 416 and 418 a second electrical contact and a cover substrate are applied using conventional methods. Following which the method 400 is terminated at step 420.

Various embodiments, as described above, provide a method of simultaneously forming electrical circuitry and functional light structures in an organic optoelectronic device. The method provided by the invention has several advantages. Since the method allows use of a transfer substrate, best possible techniques to form optimized and efficient functional light structures can be used. Also, since the electrical circuitry is transferred in such a way that the electrical circuitry does not protrude out of a surface of the curable lacquer layer, a flat surface is available for the first electrical contact to be deposited. This in turn prevents any in-homogeneity in thickness of the first electrical contact and also prevents any subsequent electronic problems or device degradation.

While the invention has been disclosed in connection with the preferred embodiments shown and described in detail, various modifications and improvements thereon will become readily apparent to those skilled in the art. Accordingly, the spirit and scope of the present invention is not to be limited by the foregoing examples, but is to be understood in the broadest sense allowable by law.

All documents referenced herein are hereby incorporated by reference.

## Claims

1. A method of simultaneously forming electrical circuitry (206, 314) and functional light structures (204) on a curable lacquer layer (106, 122) deposited on a base substrate (104, 120) for use in an organic optoelectronic device (100a, 100b), said method comprising:
- applying (406) said lacquer layer (106, 122) on said base substrate (104, 120);
- contacting (410) a transfer substrate (300) against said curable lacquer layer (106, 122), said contacting said transfer substrate (300) comprises mating a mating surface (310) of said transfer substrate (300) with said curable lacquer layer (106, 122), said mating surface (310) having said electrical circuitry (314) on a first portion and negative impressions (312) of said functional light structures (204) on a second portion and removing said transfer substrate (300); and
- curing said curable lacquer layer (106, 122), said curing facilitates affixing said electrical circuitry (314) on said curable lacquer layer (106, 122);
**characterized in that**
said electrical circuitry (314) is releasably adhered to said mating surface (310) such that adhesion between said transfer substrate (300) and said electrical circuitry (314) is substantially lesser than adhesion between said electrical circuitry (314) and said curable lacquer layer (106, 122), and
wherein said contacting comprises simultaneously embedding at least a portion of said electrical circuitry (314) in said curable lacquer layer (106, 122) and replication of said functional light structures (204) onto said curable lacquer layer (106, 122), wherein said functional light structures (204) comprises one of light trapping and light extraction.

2. The method according to claim 1, wherein said electrical circuitry (314) is electric gridlines for establishing electrical current paths across said base substrate (104, 120).

3. The method according to claim 1 or 2, wherein said transfer substrate (300) is a flexible transfer substrate.

4. The method according to one of claims 1 to 3, wherein said curable lacquer layer (106, 122) further comprises scattering particles.

5. The method according to one of claims 1 to 4, wherein said organic optoelectronic device (100a, 100b) is one of Thin Film Photovoltaic Device (TF-PV) and Organic Light Emitting Device (OLED).

6. The method according to one of claims 1 to 5, wherein said curing is selected from at least one of a thermal curing and a photo curing.

7. A transfer substrate (300) for simultaneously forming electrical circuitry (314) and functional light structures (204) on a curable lacquer layer (106, 122) of an optoelectronic device (100a, 100b), said curable lacquer layer (106, 122) being deposited on a base substrate (104, 120) of said optoelectronic device (100a, 100b), said transfer substrate (300) comprising a mating surface (310), configured to be contacted against said curable lacquer layer (106, 122),
**characterised in that**
said mating surface (310) comprises:
a first portion, said electrical circuitry (314) being releasably adhered to said first portion such that adhesion between said transfer substrate (300) and said electrical circuitry (314) is substantially lesser than adhesion between said electrical circuitry (314) and said curable lacquer layer (106, 122); and
a second portion, said second portion having negative impressions (312) of said functional light structures (204);
wherein said transfer substrate (300) enables simultaneous embedding of at least a portion of said electrical circuitry (312) in said curable lacquer layer (106, 122) and replication of said functional light structures (204) onto said curable lacquer layer (106, 122) when said mating surface (310) is contacted against said curable lacquer layer (106, 122).

8. A transfer substrate (300) according to claim 7, wherein said electrical circuitry (314) is electric gridlines for establishing electrical current paths across said base substrate (104, 120).

9. A transfer substrate (300) according to claim 7 or 8, wherein said transfer substrate (300) is a flexible transfer substrate.
